# FASCICULE DE BREVET EUROPEEN

(11) **EP 0 629 000 B1**
(45) Date de publication et mention de la délivrance du brevet: **08.12.1999**
(21) Numéro de dépôt: 94401235.0
(22) Date de dépôt: 03.06.1994
(51) Int. Cl.: H01L 23/538, H01L 25/065

(54) **Assemblage haute densité, haute fiabilité de circuits intégrés et son procédé de réalisation**
Integrierter Schaltungszusammenbau von höher Dichte und Betriebssicherheit und Herstellungsverfahren
High density and reliability integrated circuit assembly and method of making

(30) Priorité: 08.06.1993 FR 9306840
(43) Date de publication de la demande: 14.12.1994
(73) Titulaire: ALCATEL, 75008 Paris (FR)
(72) Inventeur: Muller, Eric, F-31470 Fonsorbes (FR); Masgrangeas, Marc, F-31600 Muret (FR); Coello, Vera Augustin, F-31820 Pibrac (FR)
(74) Mandataire: Smith, Bradford Lee

(56) Documents cités:
- EP-A- 0 228 953
- EP-A- 0 434 543
- FR-A- 2 295 570
- FR-A- 2 306 530
- US-A- 4 730 232
- US-A- 5 061 990

## Description

Le domaine de l'invention est celui de la microélectronique intégrée à très haute densité d'intégration.

Plus spécifiquement, l'invention concerne la réalisation de circuits dans des modules multi-puces (MCM en anglais) comportant des circuits intégrés. Une tendance actuelle du domaine concerné est la miniaturisation des réalisations, aussi bien au niveau des composants individuels, qu'au niveau des circuits incorporant ces composants. L'invention concerne plus particulièrement des circuits MCM comprenant un nombre élevé de composants élémentaires. Ces composants élémentaires peuvent être par exemple des circuits intégrés LSI.

Le problème général adressé par l'invention, résultant d'une intégration poussée, peut se poser de deux façons : soit il s'agit de réduire la taille des circuits imprimés et des équipements les incorporant, à performances égales ; soit il s'agit d'augmenter les capacités et les performances d'un équipement électronique sans pour autant augmenter la taille des circuits.

Dans certains domaines d'applications, notamment pour les applications militaires et spatiales, cette évolution est accompagnée d'un souci permanent de fiabilité. Les solutions adoptées doivent donc satisfaire simultanément les exigences des performances accrues, et être d'une fiabilité maximale mêmes dans des conditions d'environnement très sévère (vibrations, humidité, chocs, et cetera).

La croissance du nombre de composants pouvant être intégrés sur un support en deux dimensions atteint ses limites avec les largeurs minimales de traits réalisables sur des substrats semiconducteurs, de l'ordre de quelques dixièmes de micromètre. La croissance doit se poursuivre maintenant dans la troisième dimension. Les technologies de modules multi-puces (MCM en anglais) et de circuits intégrés empilés sur supports multiples présentent des solutions de l'état de l'art, quoique ces solutions ne sont pas encore appliquées à grande échelle.

Les domaines des applications spatiales et militaires, cependant, n'ont pas encore adopté ces technologies car elles ne sont pas encore éprouvées pour des environnements rigoureux. L'invention a pour but une technologie pouvant satisfaire les exigences de ces applications, tout en permettant une intégration en trois dimensions des circuits intégrés ; autrement dit, un but de l'invention est d'obtenir la haute densité d'intégration offerte par la troisième dimension, sans pour autant compromettre la très haute fiabilité en environnement hostile requise par ces applications.

L'un des problèmes rencontrés dans l'assemblage des MCM pour des applications haute densité, haute fiabilité est celui du raccordement d'un nombre élevé de "puces" entre elles, chaque puce comportant plusieurs dizaines d'entrées / sorties, sans compromettre pour autant la densité d'intégration ni la fiabilité de l'ensemble, une fois intégré.

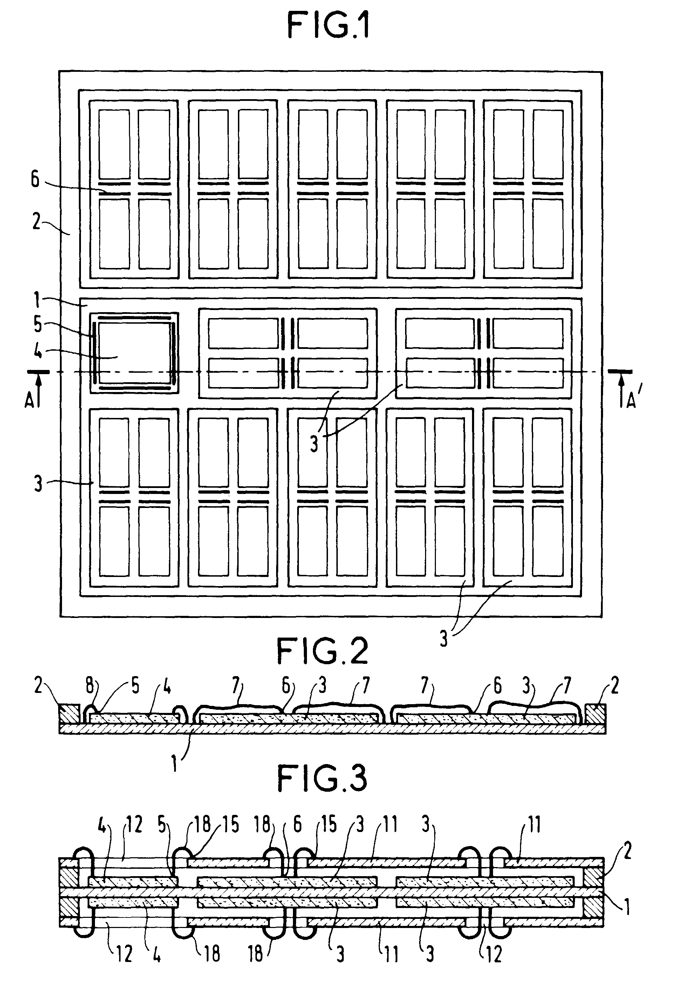

Par exemple, un MCM de l'état de l'art peut comporter une dizaine de puces nues (3, 4) sur un substrat isolant (1) monté sur un cadre métallique (2), tel que montré sur la figure 1. Les puces assurent différentes fonctions, de calcul (4), de mémoire (3), et cetera. Chaque puce peut comporter, par exemple, plusieurs dizaines de connexions entrées/sorties. Le substrat (1), dans les réalisations de l'état de l'art, constitue le support mécanique pour les puces, d'une part, et d'autre part, comporte des pistes d'interconnexions (non-montrées) ou des circuits imprimés qui permet le raccordement entre les puces elles-mêmes, et entre les puces et le monde extérieur. Vu le grand nombre de connexions à assurer, le substrat peut être par exemple un substrat "co-fritee", comportant multiples niveaux d'interconnexions par pistes conductrices photogravées sur des feuilles minces d'isolant qui sont empilées et passées ou four ensemble (le "co-frittage") pour former une structure intégrée.

Selon une variante de cette technologie enseignée dans le document D1 = EP 228 953, de telles constructions multi-niveaux pour les voies d'amenée de tensions d'alimentation peuvent être constituées par des plans conducteurs placés en couches superposées dans le capot ou dans l'embase d'un boîtier hermétique d'encapsulation. En revanche une telle construction ne permet pas le raccordement des très nombreux connexions d'entrées et de sorties rencontrés dans les applications haute densité.

Quand l'assemblage est terminé, il sera ensuite enfermé dans un boîtier hermétique, qui consiste par exemple en deux capots de fermeture (non-montrés sur cette figure), apposés sur les deux faces d'un cadre métallique (2) qui entoure le substrat (1) et les puces nues (4, 3) qui y sont rapportés.

Dans l'art connu, les entrées et sorties des puces sont raccordées à un tel circuit imprimé (sur le substrat multi-niveaux d'interconnexions) par le microcâblage, tel que montré sur la figure 2. Selon cette construction de l'art connu, les puces (3, 4) sont rapportées mécaniquement sur le substrat (1) qui comporte les pistes gravées d'interconnexions (non-montrées). Les puces (3, 4) comportent des plots d'interconnexions entrées/sorties, typiquement disposés sur leur face supérieure, leur face inférieure étant fixée sur le substrat (1). Les plots d'interconnexion (5) peuvent se trouver sur la périphérie de la puce (4), qui représente un microprocesseur, par exemple ; ou bien les plots (6) peuvent se trouver au milieu de la puce (3), qui représente une mémoire DRAM de très haute capacité, par exemple.

Le raccordement selon l'art antérieur consiste à effectuer un microcâblage, avec des fils (7,8) électriquement conducteurs, entre les plots d'interconnexions (5,6) sur les puces (3,4) et le substrat (1) multi-niveaux d'interconnexions. Tel que la figure 2 nous le montre, les fils (8) qui assurent le microcâblage entre des plots (5) en périphérie de la puce (4) et le substrat (1), sont bien plus courts que les fils (7) qui assurent le microcâblage entre les plots (6) disposés au milieu de la puce (3) et le même substrat (1). Autrement dit, l'utilisation des puces (3) ayant leurs plots (6) d'entrées/sorties disposées au milieu de la puce, implique, dans l'art connu, l'utilisation des fils (7) de microcâblage bien plus longues que les fils (8) utilisés pour le microcâblage des puces (4) ayant leurs plots (5) d'entrées/sorties sur leur périphérie.

D'où un problème pour les applications haute fiabilité. Dans le domaine spatial, par exemple, l'équipement embarqué est soumis à des vibrations très importantes lors du lancement et de l'insertion orbital de l'engin. La fiabilité de microcâblage avec des longs fils (7), dans de tels environnements hostiles, n'a pas été démontrée au jour d'aujourd'hui. En attendant une telle démonstration, l'utilisation de tels fils longs (7) est pratiquement exclue, ce qui interdit l'utilisation de puces (3) ayant leurs plots (6) d'interconnexions disposés au milieu de la puce, dans un assemblage MCM selon l'art connu, pour des applications spatiales.

Or, il existera prochainement sur le marché de semiconducteurs, des puces de mémoire RAM de très forte capacité, dont la seule configuration disponible sera celle avec les plots d'entrées/sorties au milieu. Ces mémoires ne seront pas immédiatement utilisables dans un assemblage MCM destiné à être embarqué sur satellite, pour des questions de fiabilité de leur microcâblage.

Un but de la présente invention est de pallier ces problèmes de l'art antérieur.

A ces fins, l'invention propose un assemblage haute densité, haute fiabilité de circuits intégrés multiples (MCM) selon la revendication 1.

Avantageusement, ce(s) substrat(s) d'interconnexions (11) comporte(nt) des fenêtres (12), la taille et l'emplacement de chaque fenêtre permettant l'accès aux plots (5,6) d'interconnexions sur les puces (3,4) au travers dudit substrat d'interconnexions (11). Avantageusement, le(s) substrat(s) d'interconnexions (11) est(sont) de type multicouches. Dans une réalisation préférée, le microcâblage des puces s'effectue moyennant des fils conducteurs (18) qui traversent les fenêtres (12) dudit substrat d'interconnexions (11), pour raccorder lesdits plots (5, 6) à la surface dudit substrat d'interconnexions qui est la plus éloignée desdits circuits intégrés. Cette surface est celle qui est la plus facile d'acces, facilitant l'operation de microcablage.

Selon une caractéristique, lesdits plots d'interconnexions (5) sont disposés sur la périphérie de la puce (4). Selon une autre caractéristique, lesdits plots d'interconnexions (6) sont disposés au centre des puces (3). Selon une autre caractéristique, les plots sont disposés soit en périphérie, soit au centre des puces.

Selon une caractéristique, la totalité des plots d'interconnexions (5,6) entrées/sorties de la totalité des puces (3,4) sont raccordées par microcablage à un substrat d'interconnexions (11) différent du substrat (1) qui porte les puces (3,4). Selon une autre caractéristique, une partie seulement des plots d'interconnexions (5,6) entrées/sorties sont raccordées à un substrat d'interconnexions (11) différent du substrat (1) qui porte les puces (3,4), le complément étant raccordées au substrat (1) qui porte les puces (3,4) tout comme dans l'art antérieur. La construction selon l'invention est compatible avec toute construction de l'art antérieur, et permet la réalisation d'un dispositif hybride utilisant la solution de l'art antérieur avec la solution de l'invention.

Selon une caractéristique, des circuits intégrés (3,4) sont montés sur les deux faces dudit substrat (1) de support mécanique des puces, et il y a deux substrats (11) d'interconnexions, disposés de part et d'autre dudit substrat de support (1). Selon une autre caractéristique, plusieurs substrats de support (1) peuvent être empilés, chacun étant servi d'un ou deux substrats d'interconnexions (11), disposés de côté et/ou d'autre dudit substrat de support (1) du dispositif.

Selon une caractéristique, les circuits intégrés (3,4) sont des circuit intégrés conventionnels en deux dimensions. Selon une autre caractéristique, une partie au moins desdits circuits intégrés sont des circuits intégrés 3D en trois dimensions. Dans une autre variante, tous les circuits intégrés sont des circuits intégrés 3D en trois dimensions.

L'invention propose aussi une méthode de réalisation des différentes variantes esquissées ci-dessus selon la revendication 17.

D'autres caractéristiques et avantages de l'invention ressortiront de la description détaillée qui suit, avec ses dessins annexés, dont :
- La figure 1, déjà décrite, montre schématiquement en plan et en écorché partiel un assemblage MCM (module de multiplicité de puces, ou Multi-Chip Module en anglais) selon l'art antérieur.
- la figure 2, déjà décrite, montre schématiquement et en coupe selon l'axe A-A' le dispositif de la figure 1, toujours selon l'art antérieur;
- la figure 3, déjà évoquée, montre schématiquement et en coupe un exemple d'un dispositif de l'invention, avant qu'il ne soit scellé dans un boîtier hermétique ;
- la figure 4 montre schématiquement une vue de dessus de l'exemple de la figure 3, avec des fenêtres (12) de microcâblage ;
- la figure 5 montre schématiquement et en coupe un exemple d'un boîtier hermétique qui renferme un dispositif selon l'invention, muni de ses connecteurs qui permettent l'interconnexion entre les deux substrats d'interconnexions, ainsi qu'avec le monde extérieur ;
- la figure 6 montre en plan l'extérieur d'un exemple d'un boîtier hermétiquement ferme conforme à la figure 5 ;
- la figure 7 montre schématiquement et en coupe partielle un exemple d'un empilage de boîtiers selon la figure 6 ;
- la figure 8 montre schématiquement et en coupe un exemple d'une configuration particulière d'assemblage selon l'invention, dans laquelle les puces ou circuits intégrés en deux dimensions (2D) illustrés dans les réalisations précédentes, sont remplacés par des circuits intégrés en trois dimensions (3D) ;
- la figure 9 montre schématiquement et en coupe partielle un exemple d'empilage de boîtiers comprenant des circuits intégrés 3D selon la figure 8 ;
- la figure 10 montre schématiquement et par étapes d'un exemple d'une méthode de réalisation des encapsulations MCM selon l'invention et ses principales variantes.

Sur toutes les figures, données à titre d'exemples non-limitatifs, les mêmes repères désignent les mêmes éléments. Certains passages de la description, pour des éléments qui se trouvent sur plusieurs figures, ne seront pas répétés dans la description détaillée de chaque figure.

La figure 1, déjà décrite, montre une configuration possible pour la réalisation d'un MCM. Le microcâblage n'est pas reporté sur ce dessin, ce qui fait que ce dessin peut s'appliquer aussi bien à l'art antérieur qu'à l'art enseigné par la présente demande de brevet. En plus des objets repérés sur ce dessin et déjà évoqués lors de la discussion du problème adressé par l'invention, on notera qu'il y a une partie du cadre (2) qui n'est pas périphérique aux puces (3,4). Cette partie (non-repérée) sert de blindage électromagnétique, et éventuellement de renforcement mécanique pour l'assemblage selon l'invention.

La figure 2, déjà décrite, montre un exemple d'une réalisation selon l'art antérieur. Cette réalisation est disposée sur une seule face du substrat (1), mais on peut facilement imaginer son application sur les deux faces de ce même substrat, pour obtenir une densité d'intégration encore plus élevée.

La figure 3 montre un exemple d'une réalisation selon une caractéristique de l'invention. L'exemple montré comporte deux substrats d'interconnexions (11) disposés parallèles à un premier substrat (1) qui sert de support mécanique pour des circuits intégrés (3,4) (connus de l'homme de l'art par le nom argotique "puces") disposés sur ses deux faces. Les puces (3,4) sont fixées sur le premier substrat (1) par tout moyen approprié connu de l'homme de l'art, une colle par exemple. Les substrats d'interconnexions (11) sont tenus espacés du premier substrat (1) de support, d'une distance déterminée par les dimensions des cadres (2), avantageusement mais non-exclusivement de matériau métallique. Les cadres (2) et les substrats (1,11) peuvent être assemblés par tout moyen approprié connu de l'homme de l'art, par brasage ou avec une colle par exemple. La distance de séparation entre les substrats (1,11) n'est pas critique, mais doit être au moins légèrement supérieur à la hauteur des puces (3,4) montées sur le substrat de support (1).

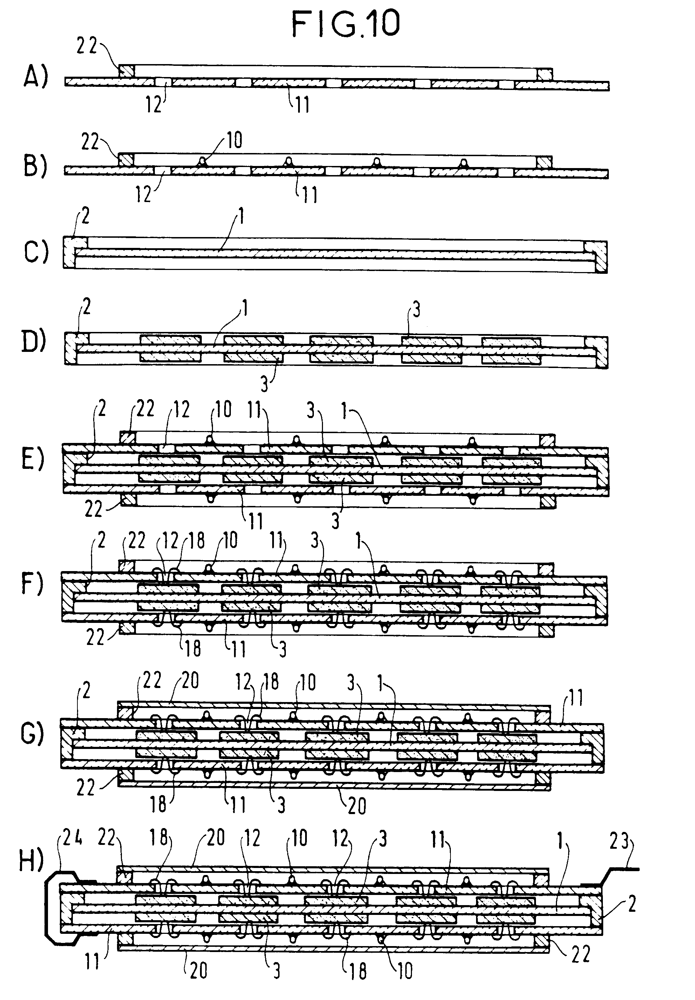

Dans l'exemple d'une réalisation montré sur la figure 3, les substrats d'interconnexions (11) sont percés de fenêtres (12), ce qui permet le passage des fils (18) de microcâblage entre les plots (5,6) d'interconnexion sur les puces (3,4) et les plots (15) d'interconnexions correspondants, disposés sur les faces externes des substrats d'interconnexions (11). Cette disposition est avantageuse pour faciliter certaines étapes de l'assemblage des MCM selon l'invention, qui seront décrites ci-après (voir la description de la figure 10). En effet, les fenêtres permettent un accès facile, simultanément aux plots de puces et aux plots des substrats d'interconnexions. Cependant, dans une réalisation moins avantageuse de l'invention, ces fenêtres ne seraient pas absolument indispensables.

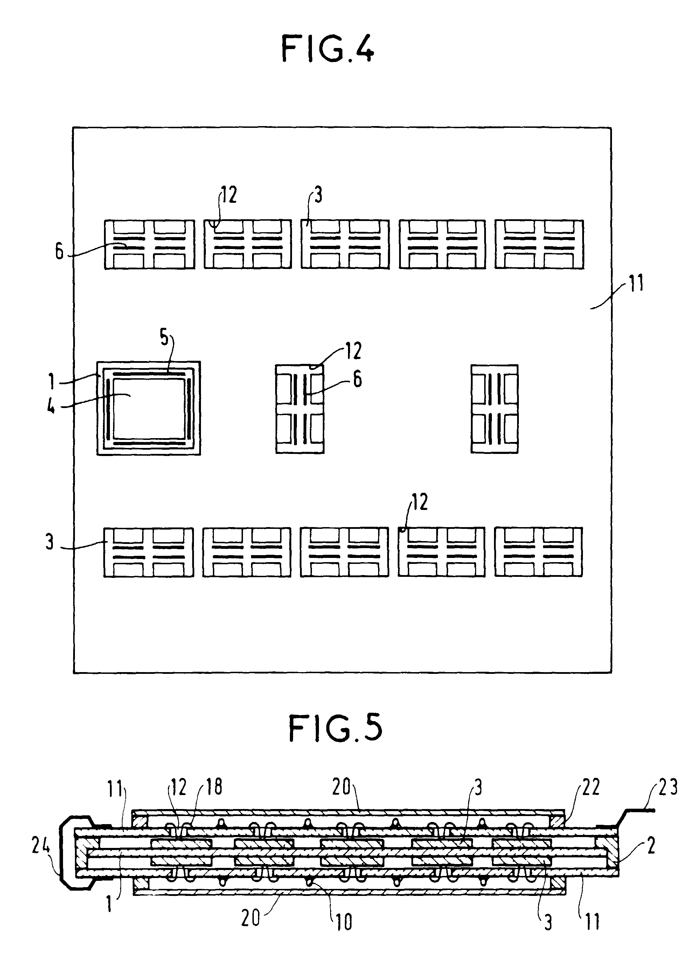

Sur la figure 4, nous voyons un assemblage selon l'invention, avant la pose de microcablage, en vue de dessus. Le substrat (1) est muni de puces (3,4) selon une configuration semblable à celle de la figure 1. Le substrat d'interconnexions (11) est posé dessus, donc nous ne voyons les puces (3,4) et le substrat de support mecanique (1) qu'à travers les fenêtres (12) prévues pour le microcablage. Les fenêtres sont disposées au-dessus des plots (5,6) d'interconnexions sur les circuits intégrés (3,4). Les plots d'interconnexions correspondants sur le substrat d'interconnexions (11) ne sont pas montrés, mais ils seront disposés autour de chaque fenêtre dans une réalisation conforme à cette figure.

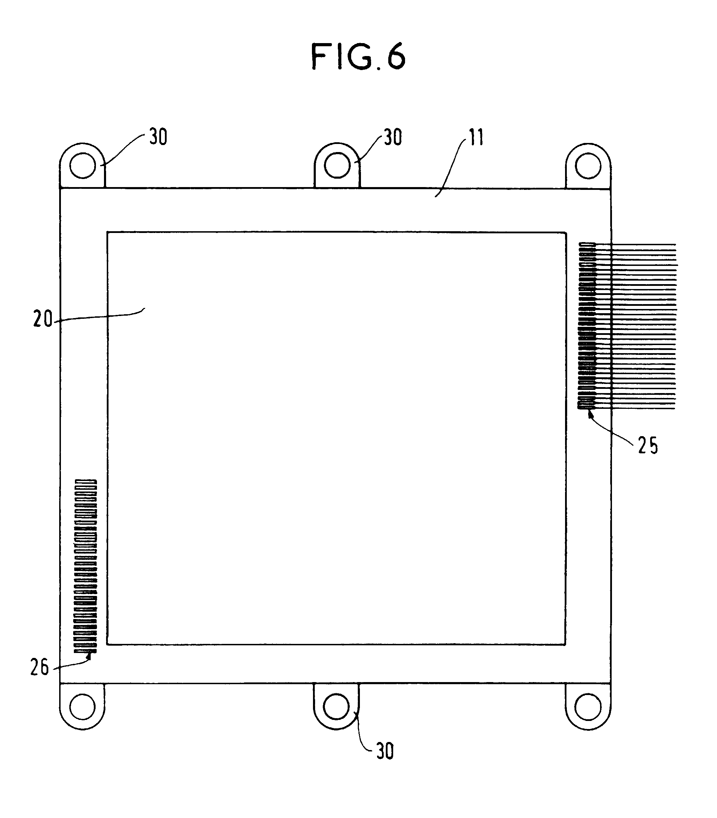

Sur la figure 5, nous voyons un exemple d'un dispositif selon l'invention, enfermé dans un boîtier hermétique. A l'interieur, les substrats de support mécanique (1) et d'interconnexions (11) sont espacés par le(s) cadre(s) métallique(s) (2). Le substrat de support (1) est muni de puces (3) sur ces deux faces. Le microcablage s'effectue par des fils (18) qui passent à travers les fenêtres (12) qui sont des trous pratiqués dans les substrats (11) de circuits imprimés multi-couches d'interconnexions. Les différents substrats sont joints aux cadre(s) (2) hermétiquement, par brasage, colle, ou toute autre moyen approprié. Accessoirement, des capacités de découplage (10) sont montrés sur cette figure, pour améliorer l'isolation contre des couplages parasites éventuels entre les fils (18) nus de microcablage.

Pour effectuer la fermeture hermétique du MCM selon cet exemple de l'invention, il suffit d'ajouter un ou plusieurs cadres (22) sur la périphérie du(des) substrat(s) d'interconnexions, et joint(s) hermétiquement à ce(s) dernier(s). Ensuite, un capot de fermeture 20 est apposé sur ce(s) cadre(s) (22), et scellé selon l'une des méthodes connues de l'homme de l'art. Cette fermeture hermétique est actuellement nécessaire pour la mise en oeuvre conventionelle d'un dispositif selon l'invention, mais il n'est pas considéré comme élément essentiel de l'invention.

Selon une caractéristique avantageuse, les circuits imprimés d'interconnexions se trouvant dans les substrats d'interconnexions (11) sont reliés entre eux par des conducteurs (24), et au monde extérieur par des conducteurs (23), ces conducteurs étant disposés parallèlement dans des rubans, dans des réalisations courantes des boîtiers hermétiques de l'art connu.

La figure 6 montre un tel boîtier hermétique, renfermant à son intérieur un dispositif selon l'invention. Vu de l'extérieur, rien de particulier ne distingue ce boîtier de ceux rencontrés dans le commerce. On voit le capot de fermeture (20) apposé sur le substrat multicouches d'interconnexions (11) qui comporte des plots d'interconnexions (26,25) pour accepter les rubans de conducteurs parallèles (24,23) que nous avons vus sur la figure 5. Les oreilles de fixation (30) permettent de fixer le boîtier mécaniquement au sein d'un équipement. Avantageusement, ces oreilles de fixation (30) sont solidaires de l'un des cadres (2) qui font partie intégrante de la structure du boîtier hermétique.

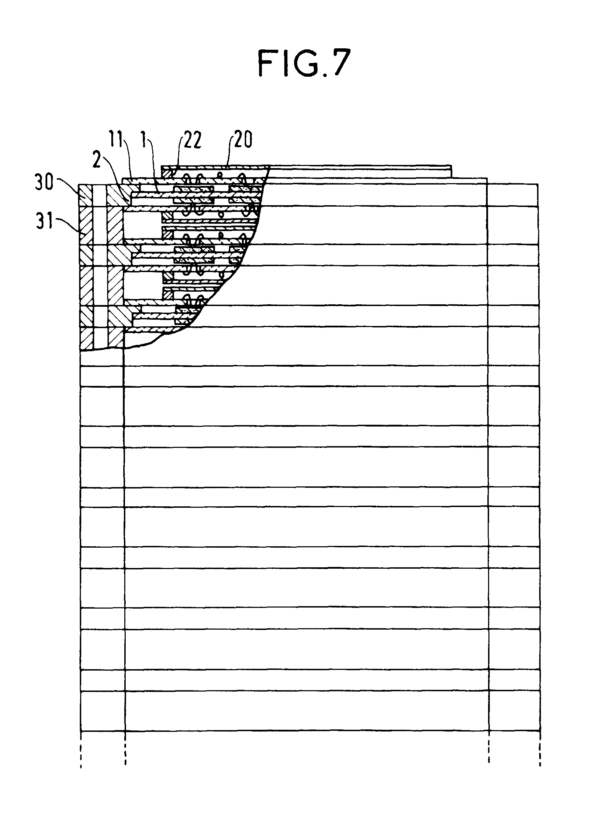

La figure 7 montre un exemple de l'empilage des boîtiers hermétiques selon la figure 6. Il suffit d'ajouter des cales ou des espaceurs (31) ayant l'épaisseur appropriée et munis de passages correspondant aux trous de fixation des oreilles (30), et un nombre de ces boîtiers peuvent être fixés au sein d'un équipement utilisant des boulons d'une longueur adéquate. De cette manière, le boîtier hermétique peut être considéré comme l'unité modulaire d'une construction en trois dimensions d'une électronique haute densité. Cette option est particulièrement attrayante pour des équipements qui peuvent tomber en panne et qui seront plus facile à depanner grâce à cette construction modulaire.

Une autre option (non-montrée) serait d'empiler un nombre de dispositifs selon l'invention à l'intérieur d'un seul boitier hermétique. L'unité modulaire d'un tel assemblage serait conforme à la figure 3, par exemple. Moyennant des espaceurs placés entre des unités modulaires conformes à la figure 3, le nombre de substrats mécaniques (1) et d'interconnexions (11) pourrait être démultiplié. Quand la structure ainsi obtenue a atteint sa taille optimale, la structure peut être enfermée dans un boîtier hermétique selon les mêmes méthodes classiques exposées précédemment.

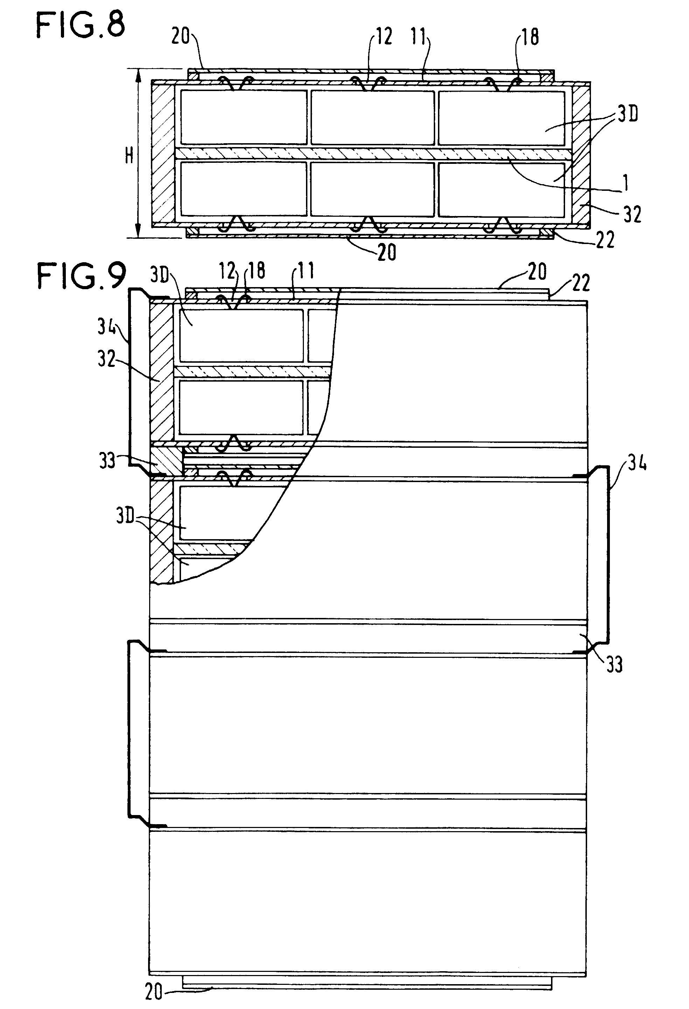

Selon une autre caractéristique de l'invention, illustrée sur la figure 8, ce sont des circuits intégrés en trois dimensions (3D) qui sont utilisés au lieu des circuits intégrés, deux dimensions (2D) montrées dans les figures précédentes. Un exemple d'un tel circuit intégré 3D est connu par la demande de brevet francais 90 15473 du 11 décembre 1990 au nom de Thomson-CSF, publication # FR 2 670 323-A1. Ces circuits 3D ont la forme d'un parallélépipède, le plus souvent rectangulaire donc avec six faces rectangulaires, et ont des plots d'interconnexions (non-montrés) sur au moins l'une de ces faces. L'invention peut être avantageusement utilisée pour effectuer les connexions par microcâblage des plots se trouvant sur la partie supérieure d'un circuit intégré 3D monté sur la face supérieure du substrat de support (1) [ou respectivement, les plots se trouvant sur la partie inférieure d'un circuit monté sur la face inférieure du substrat de support].

Dans l'exemple montré sur la figure 8, les plots d'interconnexions se trouvent sur la partie supérieure d'un circuit intégré 3D monté sur la face supérieure du substrat de support (1), et sont raccordés par le microcâblage (18) à un substrat d'interconnexions (11) ayant des fenêtres (12) à travers lesquelles le microcâblage (18) peut passer pour atteindre la surface supérieure du substrat d'interconnexions (11) supérieur, ou pour atteindre la surface inférieure du substrat d'interconnexions (11) inférieur au dispositif. Le dispositif aura une dimension d'hauteur (H) plus grande que dans le cas de circuits intégrés 2D, pour permettre l'implantation des circuits intégrés 3D. Le cadre (32) aura des dimensions plus grandes en conséquence. Mise à part cette dimension, la réalisation d'un dispositif selon l'invention est identique dans les deux cas de circuits 2D ou 3D.

Le dispositif selon l'invention est ensuite enfermé dans un boîtier hermétique par l'apposition des capots (20) sur des cadres (22) disposés sur les substrats (11) d'interconnexions, comme dans les réalisations montrées sur les figures précédentes.

Sur la figure 9, nous voyons un exemple de l'empilage des boîtiers hermétiques qui renferment des dispositifs selon l'invention portant des circuits intégrés 3D. Nous retrouvons les caractéristiques de la figure 7, déclinées par rapport aux boîtiers de la figure 8. Des câbles rubans de conducteurs parallèles permettent le raccordement des boîtiers entre eux. Les boîtiers sont tenus espacés les uns par rapport aux autres par des espaceurs (33) de taille appropriée. Toutes les autres caractéristiques repérées sur ce dessin ont déja été décrites par rapport aux figures précédentes.

Nous constatons, à l'examen des figures précédentes, que l'invention permet de réaliser un très grand nombre de configurations différentes, chaque fois en minimisant la longueur des microcâblages nécessaires aux raccordements des circuits intégrés renfermés à l'interieur d'un boîtier MCM. Ceci donne une excellente et prévisible tenue en vibrations, accélérations et chocs, apte à satisfaire les exigences des domaines d'applications spatiale et militaire.

A l'aide de la figure 10, nous décrivons un exemple d'un procédé de fabrication selon l'invention, d'un dispositif d'assemblage haute densité, haute fiabilité de circuits intégrés, jusqu'à sa mise en boîtier hermétique et le rapport de câblage externe. Des variantes d'un tel procédé seront facilement imaginées par l'homme de l'art, avec des étapes additionnelles ou en moins, ou encore des changements de l'ordre dans laquelle les étapes seront effectuées, etc. L'invention est caractérisée uniquement par les étapes qui ont un rapport avec les caractéristiques de l'assemblage selon l'invention, telles que décrites ci-dessus. Les étapes connues de l'art antérieur sont données uniquement à titre d'exemples non-limitatifs.

Faisant référence à la figure 10, un exemple d'un procédé de réalisation d'un assemblage selon l'invention comprend en outre les étapes suivantes :
- réalisation d'un substrat d'interconnexions (11) selon l'art connu ;
- rapport d'un cadre (22) sur ledit substrat d'interconnexions (voir la figure 10 A) ;
- rapport d'un cadre (2) sur un substrat (1) de support mécanique (voir la figure 10 C) ;
- rapport des circuits intégrés (3,4) sur ledit substrat de support (1) (voir la figure 10 D) ;
- rapport de(s) substrat(s) d'interconnexions (11) sur le(s) cadre(s) (2) du substrat de support (1) (voir la figure 10 E) ;
- microcâblage des circuits intégrés (3,4) (voir la figure 10 F) ;
ledit procédé étant caractérisé en ce que : au moins une partie dudit microcâblage est raccordé à un substrat d'interconnexions (11) différent et distinct dudit substrat (1) sur lequel lesdits circuits intégrés (3,4) sont disposés (voir la figure 10 F).

Pour la mise en oeuvre pratique de l'invention, et selon une réalisation préférée, des étapes complémentaires seront préconisées, qui sont aussi illustrées sur la figure 10. Le procédé de réalisation préférentielle d'un assemblage selon l'invention comprend, outre les étapes déja mentionnées, les étapes suivantes :
- réalisation d'un substrat d'interconnexions (11) comportant des fenêtres (12) (telles que montrées sur la figure 10 A) ;
- rapport des capacités de découplage (10) sur ledit substrat d'interconnexions (11) entre les fenêtres (12) pour minimiser des couplages parasites éventuels entre les fils de microcâblage (18) (voir la figure 10 B) ;
- microcâblage des circuits intégrés (3,4), dont une partie au moins à travers desdites fenêtres (12), (voir la figure 10 F) ;
- rappport d'au moins un capot de fermeture hermétique (20) sur ledit cadre (22), et scellement hermétique selon l'une des méthodes connues de l'homme de l'art (voir la figure 10 G) ;
- rapport de fils de connexions (24) entre substrats d'interconnexions (11), le cas échéant, (voir la figure 10 H) ;
- rapport de fils de connexions (23) sur un substrat d'interconnexions (11), destinés à être raccordés au sein d'un équipement électronique dans lequel le dispositif selon l'invention sera implanté (voir la figure 10 H).

Le procédé selon l'invention peut être adapté à toutes les configurations et réalisations mentionnées ci-dessus à titre d'exemple, ainsi à une multitude d'autres exemples qui n'ont pas été déclinés explicitement.

L'invention permet de réduire considérablement la vulnérabilité de tels assemblages haute densité de circuits intégrés à des environnements sévères qui caractérisent les applications spatiale, militaire, et quelques secteurs de l'électronique embarquée ou mobile. Pour les applications qui requierent une prévision de la fiabilité des réalisations avant leur déploiement, l'assemblage selon l'invention ainsi que le procédé selon l'invention ont l'avantage d'utiliser que des technologies déja éprouvées et caractérisées pour de telles applications. Leur mise en oeuvre peut être immédiate.

## Revendications

1. Assemblage haute densité, haute fiabilité de circuits intégrés multiples (MCM) comprenant :
- au moins un substrat de support(1) ayant deux faces planes sensiblement parallèles,
- une pluralité de circuits intégrés (3,4) fixés sur au moins une desdites faces dudit substrat de support (1), lesdits circuits intégrés (3,4) comportant en outre des plots (5,6) d'interconnexions d'entrées et de sorties,
- un cadre (2) en une ou plusieurs parties disposée(s) sur la périphérie de ladite au moins une desdites faces dudit substrat de support (1) et autour desdits circuits intégrés (3,4), ledit cadre ayant une hauteur plus grande que la hauteur desdits circuits intégrés (3,4) ;
- des fils de microcâblage (18) raccordés àuxdits plots d'interconnexion (5,6) desdits circuits integrés (3,4) ;
- au moins un substrat d'interconnexions (11) ayant deux faces planes sensiblement parallèles, disposé sur ledit cadre (2) et s'étendent sensiblement parallèlement à ladite au moins une desdites faces dudit substrat de support (1), ce substrat d'interconnexion (11) comportant des plots d'interconnexion (15) et des pistes conductrices conduisant à ces plots (15) ;
**caractérisé en ce que** :
au moins une partie desdits plots (5,6) d'interconnexions desdits circuits intégrés (3,4) sont raccordés directement àux plots d'interconnexion (15) sur aux moins une des deux faces dudit substrat d'interconnexions (11) par lesdits fils de microcâblage (18).

2. Assemblage selon la revendication 1, caractérisé en ce que lesdits plots (15) du substrat d'interconnexion sont disposés sur celle des deux faces du(des)dit(s) substrat(s) d'interconnexions (11) qui est la plus éloingée desdits circuits intégrés (3,4), ce substrat (11) comportant des ouvertures (12), la taille et l'emplacement de chaque ouverture permettant l'accès aux plots (5,6) d'interconnexions sur les circuits intégrés (3,4) au travers dudit substrat d'interconnexions (11).

3. Assemblage selon l'une quelconque des revendications 1 à 2, caractérisé en ce que le(s)dit(s) substrat(s) d'interconnexions (11) est(sont) de type multi-niveaux.

4. Assemblage selon l'une quelconque des revendications 1 à 3, caractérisé en ce que lesdits plots d'interconnexions (5) sont disposés sur la périphérie des circuits intégrés (4).

5. Assemblage selon l'une quelconque des revendications 1 à 3, caractérisé en ce que lesdits plots d'interconnexions (6) sont disposés au centre des circuits intégrés (3).

6. Assemblage selon l'une quelconque des revendications 1 à 3, caractérisé en ce que lesdits plots d'interconnexions (6,5) sont disposés aux centres d'une partie des circuits intégrés (3), et disposés sur la périphérie d'une partie complémentaire des circuits intégrés (4) .

7. Assemblage selon l'une quelconque des revendications 1 à 6, caractérisé en ce que la totalité des plots d'interconnexions (5,6) entrées/sorties de la totalité des circuits intégrés (3,4) sont raccordées par lesdits fils de microcablage (18) à au moins un substrat d'interconnexions (11) différent dudit substrat de support (1) qui porte les circuits intégrés (3,4).

8. Assemblage selon l'une quelconque des revendications 1 à 6, caractérisé en ce qu'une partie seulement des plots d'interconnexions (5,6) entrées/sorties sont raccordées à un substrat d'interconnexions (11) différent du substrat de support (1) qui porte les circuits intégrés (3,4), le complément étant raccordé au substrat de support(1) qui porte les circuits intégrés (3,4).

9. Assemblage selon l'une quelconque des revendications 1 à 8, caractérisé en ce que lesdits circuits intégrés (3,4) sont montés sur les deux faces dudit substrat (1) de support .

10. Assemblage selon la revendication 9, caractérisé en ce qu'il y a deux substrats (11) d'interconnexions, disposés de part et d'autre dudit substrat de support (1).

11. Assemblage selon l'une quelconque des revendications 1 à 10, caractérisé en ce que lesdits circuits intégrés (3,4) sont des circuits intégrés conventionnels en deux dimensions.

12. Assemblage selon l'une quelconque des revendications 1 à 10, caractérisé en ce qu'une partie au moins desdits circuits intégrés sont des circuits intégrés 3D en trois dimensions.

13. Assemblage selon l'une quelconque des revendications 1 à 10, caractérisé en ce que tous lesdits circuits intégrés sont des circuits intégrés 3D en trois dimensions.

14. Assemblage d'une pluralité d'assemblages élémentaires selon l'une quelconque des revendications 1 à 13, caractérisé en ce qu'il comprend une pluralité de substrats de support (1) empilés, chacun des substrats de support étant servi d'un ou deux substrats d'interconnexions (11), disposés de côté et/ou d'autre de chaque substrat de support (1).

15. Composant pour équipement électronique, comprenant en outre un assemblage selon l'une quelconque des revendications 1 à 14, enfermé dans un boîtier hermétique.

16. Assemblage d'une pluralité de composants selon la revendication 15.

17. Procédé de réalisation d'un assemblage selon l'une des revendications précédentes, ledit procédé comprennant en outre les étapes suivantes :
- réalisation d'un substrat d'interconnexions (11)
- rapport d'un cadre (2) sur un substrat (1) de support mécanique
- rapport des circuits intégrés (3,4) sur ledit substrat de support (1)
- rapport de(s) substrat(s) d'interconnexions (11) sur le(s) cadre(s) (2) du substrat de support (1)
- microcâblage des circuits intégrés (3,4) ;
ledit procédé étant caractérisé en ce que : au moins une partie dudit microcâblage est raccordé directement à un substrat d'interconnexions (11) différent et distinct dudit substrat (1) sur lequel lesdits circuits intégrés (3,4) sont disposés.

18. Procédé de réalisation d'un assemblage selon la revendication 17, ledit procédé comprenant en outre les étapes suivantes :
- réalisation d'un substrat d'interconnexions (11) comportant des fenêtres (12),
- rapport des capacités de découplage (10) sur ledit substrat d'interconnexions (11) entre les fenêtres (12) ,
- microcâblage des circuits intégrés (3,4), dont une partie au moins à travers desdites fenêtres (12),
- rapport de fils de connexions (24) entre substrats d'interconnexions (11), le cas échéant,
- rapport de fils de connexions (23) sur un substrat d'interconnexions (11), destinés à être raccordés au sein d'un équipement électronique dans lequel l'assemblage selon l'une quelconque des revendications 1-16 sera implanté.

## Claims

1. High-density and highly reliable multiple integrated circuit assembly (MCM) comprising:
- at least one support substrate (1) having two substantially parallel plane sides,
- a plurality of integrated circuits (3, 4) fixed on at least one of said sides of said support substrate (1), said integrated circuits (3, 4) further including input and output interconnection lands (5, 6);
- a frame (2) comprising one or more parts disposed at the perimeter of said at least one of said sides of said support substrate (1) and around said integrated circuits (3, 4), said frame having a height greater than the height of said integrated circuits (3, 4);
- microwired wires (18) connected to said interconnection lands (5, 6) of said integrated circuites (3, 4);
- at least one interconnection substrate (11) having two substantially parallel plane sides, disposed on said frame (2) and extended substantially parallel to said at least one of said sides of said support substrate (1), the interconnection substrate (11) including interconnection lands (15) and conductive tracks leading to said lands (15);
**characterized in that:**
at least some interconnection lands (5, 6) of said integrated circuits (3, 4) are connected directly to the interconnection lands (15) on at least one side of said interconnection substrate (11) by said microwired wires (18).

2. Assembly according to claim 1 characterized in that said lands (15) of the interconnection substrate are disposed on the side of the interconnection substrate(s) (11) that is the furthest away from said integrated circuits (3, 4), said substrate (11) including apertures (12), whose size and location provide access to the interconnection lands (5, 6) on the integrated circuits (3, 4) through said interconnection substrate (11).

3. Assembly according to claim 1 or claim 2 characterized in that said interconnection substrate(s) (11) is/are a multilevel substrate.

4. Assembly according to any one of claims 1 to 3 characterized in that said interconnection lands (5) are on the perimeter of the integrated circuits (4).

5. Assembly according to any one of claims 1 to 3 characterized in that said interconnection lands (6) are at the center of the integrated circuits (4).

6. Assembly according to any one of claims 1 to 3 characterized in that said interconnection lands (6, 5) are at the center of some of the integrated circuits (3) and at the perimeter of others of the integrated circuits (4).

7. Assembly according to any one of claims 1 to 6 characterized in that all the input/output interconnection lands (5, 6) of all the integrated circuits (3, 4) are connected by said microwired wires (18) to at least one interconnection substrate (11) separate from said support substrate (1) carrying the integrated circuits (3, 4).

8. Assembly according to any one of claims 1 to 6 characterized in that some of the input/output interconnection lands (5, 6) are connected to an interconnection substrate (11) separate from the support substrate (1) carrying the integrated circuits (3, 4), the remainder being connected to the support substrate (1) carrying the integrated circuits (3, 4).

9. Assembly according to any one of claims 1 to 8 characterized in that said integrated circuits (3, 4) are mounted on both sides of said support substrate (1).

10. Assembly according to claim 9 characterized in that there are two interconnection substrates (11), one on each side of said supporting substrate (1).

11. Assembly according to any one of claims 1 to 10 characterized in that said integrated circuits (3, 4) are conventional two-dimensional integrated circuits.

12. Assembly according to any one of claims 1 to 10 characterized in that at least some of said integrated circuits are three-dimensional (3D) integrated circuits.

13. Assembly according to any one of claims 1 to 10 characterized in that all said integrated circuits are three-dimensional (3D) integrated circuits.

14. Assembly of a plurality of assemblies according to any one of claims 1 to 13 characterized in that it comprises a stacked plurality of supporting substrates (1) each served by one or two interconnection substrates (11) disposed on one or both sides of the supporting substrate (1).

15. Component for electronic equipment further comprising an assembly according to any one of claims 1 to 14 enclosed in a hermetically sealed case.

16. Assembly of a plurality of components according to claim 15.

17. Method of manufacturing an assembly according to any one of the preceding claims further comprising the following steps:
- producing an interconnection substrate (11),
- attaching a frame (2) to a mechanical support substrate (1),
- attaching integrated circuits (3, 4) to said support substrate (1),
- attaching interconnection substrates(s) (11) to the frame(s) (2) of the support substrate (1),
- microwiring the integrated circuits (3, 4);
said method being characterized in that at least some of said microwiring is connected directly to an interconnection substrate (11) separate from said substrate (1) carrying said integrated circuits (3, 4).

18. Method according to claim 17 for manufacturing an assembly, said method further comprising the following steps:
- producing an interconnection substrate (11) including apertures (12),
- attaching decoupling capacitors (10) to said interconnection substrate (11) between the apertures (12),
- microwiring integrated circuits (3, 4), at least some of them through said apertures (12),
- attaching connecting wires (24) between interconnection substrates (11), if necessary,
- attaching connecting wires (23) to an interconnection substrate (11) adapted to be connected within electronic equipment in which the assembly according to any one of claims 1 to 16 is installed.

## Patentansprüche

1. Aufbau von mehrfachen integrierten Schaltungen (MCM) mit hoher Dichte und hoher Zuverlässigkeit, welcher umfaßt:
- wenigstens ein Trägersubstrat (1) mit zwei im wesentlichen parallelen, ebenen Flächen,
- eine Vielzahl von integrierten Schaltungen (3, 4), die auf wenigstens einer der Flächen des Trägersubstrats (1) angebracht sind, wobei die integrierten Schaltungen (3, 4) außerdem Eingangs- und Ausgangsverbindungskontakte (5, 6) aufweisen,
- einen Rahmen (2) an einem oder mehreren am Umfang der wenigstens einen der Flächen des Trägersubstrats (1) und um die integrierten Schaltungen (3, 4) herum angeordneten Teilen, wobei der Rahmen eine größere Höhe als die Höhe der integrierten Schaltungen (3, 4) aufweist,
- Mikroverkabelungsdrähte (18), die mit den Verbindungskontakten (5, 6) der integrierten Schaltungen (3, 4) verbunden sind,
- wenigstens ein Verbindungssubstrat (11) mit wenigstens zwei im wesentlichen parallelen, ebenen Flächen, das auf dem Rahmen (2) angeordnet ist und sich im wesentlichen parallel zu der wenigstens einen der Flächen des Trägersubtrats (1) erstreckt, wobei dieses Verbindungssubstrat (11) Verbindungskontakte (15) und Leiterbahnen aufweist, die zu diesen Kontakten (15) führen,
dadurch gekennzeichnet, daß
wenigstens ein Teil der Verbindungskontakte (5, 6) der integrierten Schaltungen (3, 4) durch die Mikroverkabelungsdrähte (18) mit den Verbindungskontakten (15) auf wenigstens einer der beiden Flächen des Verbindungssubstrats (11) direkt verbunden sind.

2. Aufbau nach Anspruch 1, dadurch gekennzeichnet, daß die Kontakte (15) des Verbindungssubstrats auf derjenigen der beiden Flächen des (der) Verbindungssubstrat(e) (11) angeordnet sind, die von den integrierten Schaltungen (3, 4) am weitesten entfernt ist, wobei dieses Substrat (11) Öffnungen (12) aufweist, wobei die Größe und der Ort jeder Öffnung den Zugang zu Verbindungskontakten (5, 6) an den integrierten Schaltungen (3, 4) durch das Verbindungssubstrat hindurch gestatten.

3. Aufbau nach einem der Ansprüche 1 bis 2, dadurch gekennzeichnet, daß das (die) Verbindungssubstrat(e) (11) vom Mehrebenentyp ist (sind).

4. Aufbau nach einem der Ansprüche 1 bis 3, dadurch gekennzeichnet, daß die Verbindungskontakte (5) am Umfang der integrierten Schaltungen (4) angeordnet sind.

5. Aufbau nach einem der Ansprüche 1 bis 3, dadurch gekennzeichnet, daß die Verbindungskontakte (6) in der Mitte der integrierten Schaltungen (3) angeordnet sind.

6. Aufbau nach einem der Ansprüche 1 bis 3, dadurch gekennzeichnet, daß die Verbindungskontakte (6, 5) in den Mitten eines Teils der integrierten Schaltungen (3) und am Umfang eines komplementären Teils der integrierten Schaltungen (4) angeordnet sind.

7. Aufbau nach einem der Ansprüche 1 bis 6, dadurch gekennzeichnet, daß die gesamten Eingangs/Ausgangsverbindungskontakte (5, 6) der gesamten integrierten Schaltungen (3, 4) durch die Mikroverkabelungsdrähte (18) mit wenigstens einem Verbindungssubstrat (11) verbunden sind, das vom Trägersubstrat (1), das die integrierten Schaltungen (3; 4) trägt, verschieden ist.

8. Aufbau nach einem der Ansprüche 1 bis 6, dadurch gekennzeichnet, daß nur ein Teil der Eingangs/Ausgangsverbindungskontakte (5, 6) mit einem Verbindungssubstrat (11) verbunden sind, das vom Trägersubstrat (1), das die integrierten Schaltungen (3, 4) trägt, verschieden ist, wobei das Komplement mit dem Trägersubstrat (1) verbunden ist, das die integrierten Schaltungen (3, 4) trägt.

9. Aufbau nach einem der Ansprüche 1 bis 8, dadurch gekennzeichnet, daß die integrierten Schaltungen (3, 4) auf den beiden Flächen des Trägersubstrats (1) angebracht sind.

10. Aufbau nach Anspruch 9, dadurch gekennzeichnet, daß es zwei Verbindungssubstrate (11) gibt, die beiderseits des Trägersubstrats (1) angeordnet sind.

11. Aufbau nach einem der Ansprüche 1 bis 10, dadurch gekennzeichnet, daß die integrierten Schaltungen (3, 4) herkömmliche zweidimensionale integrierte Schaltungen sind.

12. Aufbau nach einem der Ansprüche 1 bis 10, dadurch gekennzeichnet, daß wenigstens ein Teil der integrierten Schaltungen dreidimensionale integrierte 3D-Schaltungen sind.

13. Aufbau nach einem der Ansprüche 1 bis 10, dadurch gekennzeichnet, daß alle integrierten Schaltungen dreidimensionale integrierte 3D-Schaltungen sind.

14. Aufbau aus einer Vielzahl von Elementaraufbauten nach einem der Ansprüche 1 bis 13, dadurch gekennzeichnet, daß er eine Vielzahl von gestapelten Trägersubstraten (1) umfaßt, wobei jedes der Trägersubstrate mit einem oder zwei Verbindungssubstraten (11) versehen ist, die auf der einen und/oder der anderen Seite jedes Trägersubstrats (1) angeordnet sind.

15. Bauteil für eine elektronische Anlage, das außerdem einen Aufbau nach einem der Ansprüche 1 bis 14, eingeschlossen in einem hermetischen Gehäuse, umfaßt.

16. Aufbau aus einer Vielzahl von Bauteilen nach Anspruch 15.

17. Verfahren zur Herstellung eines Aufbaus nach einem der vorhergehenden Ansprüche, wobei das Verfahren außerdem die folgenden Schritte umfaßt:
- Herstellung eines Verbindungssubstrates (11),
- Aufsetzen eines Rahmens (2) auf ein mechanisches Trägersubstrat (1),
- Aufsetzen der integrierten Schaltungen (3, 4) auf das Trägersubstrat (1),
- Aufsetzen des (der) Verbindungssubstrats (-substrate) (11) auf den (die) Rahmen (2) des Trägersubstrats (1),
- Mikroverkabelung der integrierten Schaltungen (3, 4),
dadurch gekennzeichnet, daß wenigstens ein Teil der Mikroverkabelung mit einem Verbindungssubstrat (11) direkt verbunden ist, das vom Trägersubstrat (1), auf welchem die integrierten Schaltungen (3, 4) angeordnet sind, verschieden und getrennt ist.

18. Verfahren zur Herstellung eines Aufbaus nach Anspruch 17, wobei das Verfahren außerdem die folgenden Schritte umfaßt:
- Herstellung eines Verbindungssubstrates (11), das Fenster (12) aufweist,
- Aufsetzen von Entkopplungskapazitäten (10) auf das Verbindungssubstrat (11) zwischen den Fenstern (12),
- Mikroverkabelung der integrierten Schaltungen (3, 4), davon wenigstens ein Teil durch die Fenster (12) hindurch,
- gegebenenfalls Aufsetzen von Verbindungsdrähten (24) zwischen den Verbindungssubstraten (11),
- Aufsetzen von Verbindungsdrähten (23) auf ein Verbindungssubstrat (11), die dazu bestimmt sind, im inneren einer elektronischen Anlage angeschlossen zu werden, in welche der Aufbau nach einem der Ansprüche 1 bis 16 eingesetzt wird.
